(19) Europäisches Patentamt
European Patent Office
Office européen des brevets

(11) EP 4 675 295 A1

(12) **EUROPEAN PATENT APPLICATION**
published in accordance with Art. 153(4) EPC

(43) Date of publication:
**07.01.2026 Bulletin 2026/02**

(21) Application number: **24900903.6**

(22) Date of filing: **11.11.2024**

(51) International Patent Classification (IPC):
***G01R 31/396*** *(2019.01)* ***G01R 31/3842*** *(2019.01)*
***G01R 31/392*** *(2019.01)* ***G01R 31/367*** *(2019.01)*
***G01R 19/165*** *(2006.01)* ***G01R 19/10*** *(2006.01)*
***B60L 58/10*** *(2019.01)*

(52) Cooperative Patent Classification (CPC):
**B60L 58/10; G01R 19/10; G01R 19/165; G01R 31/367; G01R 31/3842; G01R 31/392; G01R 31/396;** Y02E 60/10

(86) International application number:
**PCT/KR2024/017773**

(87) International publication number:
**WO 2025/121716 (12.06.2025 Gazette 2025/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.12.2023 KR 20230175821**

(71) Applicant: **LG Energy Solution, Ltd.**
**Seoul 07335 (KR)**

(72) Inventors:
- **KIM, Tae-In**
  **Daejeon 34122 (KR)**
- **SUN, Kyung-Eun**
  **Daejeon 34122 (KR)**
- **BAE, Yoon-Jung**
  **Daejeon 34122 (KR)**

(74) Representative: **Goddar, Heinz J.**
**Boehmert & Boehmert Anwaltspartnerschaft mbB**
**Pettenkoferstrasse 22**
**80336 München (DE)**

(54) **BATTERY DIAGNOSIS APPARATUS AND BATTERY DIAGNOSIS METHOD**

(57) A battery diagnosis apparatus and a battery diagnosis method are disclosed. The battery diagnosis apparatus according to the present disclosure includes a data processing unit configured to acquire a differential profile indicating charge/discharge characteristics of a battery cell, a calculation unit configured to determine a peak comparison value based on a first peak point and a second peak point, wherein the first peak point and the second peak point are any two of a plurality of peak points when the plurality of peak points exist in the differential profile, and a diagnosis unit configured to diagnose a condition of the battery cell based on the peak comparison value.

FIG. 1

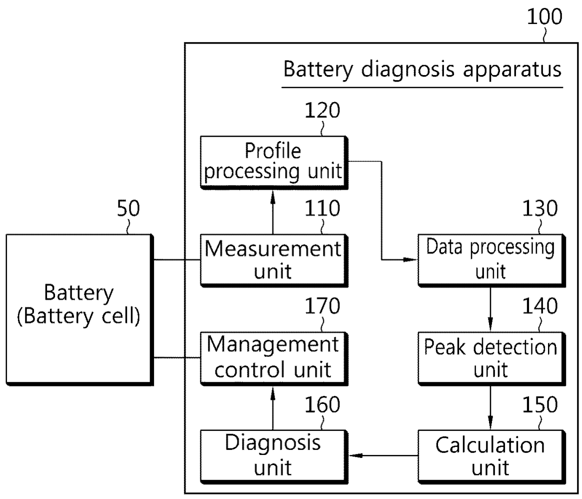


EP 4 675 295 A1

# Description

## TECHNICAL FIELD

The present disclosure relates to technology that diagnoses the condition of a battery by analyzing a differential profile reflecting charge/discharge characteristics of active materials of the battery.

This application claims priority to Korean Patent Application No. 10-2023-0175821 filed on December 6, 2023 in the Republic of Korea, the disclosure of which is incorporated herein by reference.

## BACKGROUND

Recently, there has been a rapid increase in the demand for portable electronic products such as laptop computers, video cameras and mobile phones, and with the increasing development of electric vehicles, accumulators for energy storage, robots and satellites, many studies are being made on high performance batteries that may be repeatedly charged and discharged.

Commercially available batteries include nickel-cadmium batteries, nickel-hydrogen batteries, nickel-zinc batteries, lithium batteries and the like, and among them, lithium batteries have little or no memory effect compared to nickel-based batteries, and thus they are attracting attention for their advantages that recharging may be done whenever it is convenient, the self-discharge rate is very low and the energy density is high.

As opposed to energy generation methods based on fossil fuel, secondary batteries generate energy by electrochemical reaction, so when the charge/-discharge cycles continue or repeat, secondary batteries cannot maintain the performance at Beginning of Life (BOL) and gradually degrade or age.

As the use (charge/discharge) of batteries continues, usability reduces due to capacity or output decline and safety acts as a risk factor, and to maintain continuity of normal operation, control for limited use, determine when to replace and improve efficiency of battery reuse or recycling, it is necessary to accurately diagnose the current condition of batteries.

Batteries generally include a plurality of cells or banks that are grouped through parallel electrical connection. Accordingly, when some of the battery cells are abnormal, the entire operation performance of the batteries may decrease.

Therefore, accurately diagnosing the current condition of the battery cells and performing appropriate subsequent control is essential to maintain the normal operation performance of the batteries including the plurality of battery cells.

Recently, to improve the operation characteristics of the battery cells, the battery cells usually include a mixed positive electrode material (for example, NCM, NCA, etc.) and a mixed negative electrode material including a plurality of active materials, for example, nickel, cobalt, manganese or aluminum at an optimal mix ratio.

Because the mixed positive electrode material includes the plurality of active materials having different charge/discharge characteristics, a degradation deviation occurs in which the specific active material degrades faster than other active material and as the life (charge/-discharge) cycles of the battery cells are repeated, the degradation deviation increases greatly and fast. The degradation characteristics of the mixed positive electrode material may be the same as the case with the mixed negative electrode material. In addition, as the battery cells degrade, the deviation of charge/discharge characteristics between at least one positive electrode active material and at least one negative electrode active material may also gradually increase.

Accordingly, there is a need to accurately track conditions of battery cells in order to maintain the normal and stable operation of the battery cells including two or more types of active materials.

## DISCLOSURE

### Technical Problem

The present disclosure is designed to solve the above-described problems, and therefore the present disclosure is directed to providing a battery diagnosis apparatus and method for diagnosing the current condition of a battery cell quickly with high reliability by using a differential profile of the battery cell, which can be acquired and generated through a straightforward method.

These and other objectives and advantages of the present disclosure may be understood from the following description and will become more fully apparent from the exemplary embodiments of the present disclosure. Also, it will be easily understood that the objectives and advantages of the present disclosure may be realized by the means set forth in the appended claims and a combination thereof.

### Technical Solution

A battery diagnosis apparatus according to an aspect of the present disclosure includes a data processing unit configured to acquire a differential profile indicating charge/discharge characteristics of a battery cell, a calculation unit configured to determine a peak comparison value based on a first peak point and a second peak point, wherein the first peak point and the second peak point are any two of a plurality of peak points when the plurality of peak points exist in the differential profile, and a diagnosis unit configured to diagnose a condition of the battery cell based on the peak comparison value.

The first peak point and the second peak point may indicate the charge/discharge characteristics of two active materials included in the battery cell.

The battery diagnosis apparatus may further include a management control unit configured to perform control to limit the charge and discharge of the battery cell when the battery cell is diagnosed as abnormal.

The calculation unit may be configured to determine any one of the plurality of peak points having a smallest voltage difference from a reference peak point as the first peak point. The calculation unit may be configured to determine the other one of the plurality of peak points having a smaller voltage value than the first peak point and a smallest voltage difference from the first peak point as the second peak point.

The calculation unit may be configured to determine the peak comparison value based on a ratio between a differential capacity value of the first peak point and a differential capacity value of the second peak point.

The diagnosis unit may be configured to diagnose the battery cell as abnormal when the peak comparison value is larger than a reference comparison value. The diagnosis unit may be configured to diagnose the battery cell as normal when the peak comparison value is equal to or smaller than the reference comparison value.

The diagnosis unit may be configured to generate diagnosis information indicating that the battery cell is abnormal when the battery cell is diagnosed as abnormal.

The diagnosis unit may be configured to diagnose the condition of the battery cell based on history data of the peak comparison value when a single peak point exists in the differential profile.

The diagnosis unit may be configured to diagnose the battery cell as abnormal when at least one previous peak comparison value is identified from the history data.

The diagnosis unit may be configured to diagnose the battery cell as normal when a previous peak comparison value is not identified from the history data.

A battery pack according to another aspect of the present disclosure includes the battery diagnosis apparatus.

An electric vehicle according to still another aspect of the present disclosure includes the battery diagnosis apparatus.

A battery diagnosis method according to yet another aspect of the present disclosure includes the steps of acquiring a differential profile indicating charge/-discharge characteristics of a battery cell, determining a peak comparison value based on a first peak point and a second peak point, wherein the first peak point and the second peak point are any two of a plurality of peak points when the plurality of peak points exist in the differential profile, and diagnosing a condition of the battery cell based on the peak comparison value.

The step of determining the peak comparison value may include the steps of determining any one of the plurality of peak points having a smallest voltage difference from a reference peak point as the first peak point, and determining the other one of the plurality of peak points having a smaller voltage value than the first peak point and a smallest voltage difference from the first peak point as the second peak point.

The step of determining the peak comparison value may include determining the peak comparison value based on a ratio between a differential capacity value of the first peak point and a differential capacity value of the second peak point.

## Effects of the Invention

According to at least one of the embodiments of the present disclosure, it may be possible to effectively diagnose the current condition of the battery cell by a more straightforward method using degradation induced characteristics changes of the battery cell systematically combined with the data analysis process.

Additionally, according to at least one of the embodiments of the present disclosure, it may be possible to diagnose the current condition of the battery cell more easily and quickly through the process of analyzing and utilizing the differential profile representing the characteristics of the battery cell, and the differential profile may be updated and used in time series, so the current condition of the battery cell that dynamically changes may be reflected more substantively.

Additionally, according to at least one of the embodiments of the present disclosure, as the degradation level of the battery cell may be generated as quantitative information for future use, it may be possible to diagnose the current condition of the battery cell more precisely, and perform the subsequent control process of, for example, limiting the charge and discharge more effectively by using the same.

Further, the process of the present disclosure may be implemented through software that may be installed at battery management systems (BMS) commonly used in battery devices or systems, thereby providing higher scalability.

The effects of the present disclosure are not limited to the aforementioned effects, and these and other effects will be clearly understood by those skilled in the art from the appended claims.

## BRIEF DESCRIPTION OF THE DRAWINGS

The accompanying drawings illustrate the exemplary embodiments of the present disclosure and together with the following detailed description, serve to provide a better understanding of the technical aspect of the present disclosure, and thus the present disclosure should not be construed as being limited to the drawings.

FIG. 1 is a block diagram showing a detailed configuration of a battery diagnosis apparatus according to an embodiment of the present disclosure.

FIG. 2 is a block diagram exemplarily showing a detailed configuration of a calculation unit shown in FIG. 1.

FIG. 3 is a block diagram exemplarily showing a detailed description of a diagnosis unit shown in FIG. 1.

FIG. 4 is a flowchart illustrating a process of diagnosing the condition of a battery cell according to an embodiment of the present disclosure.

FIG. 5 is a flowchart exemplarily illustrating a process for generating a peak comparison value of a battery cell.

FIG. 6 is a flowchart illustrating a process of diagnosing the condition of a battery cell according to an embodiment of the present disclosure.

FIG. 7 is an up-scaled diagram of a differential profile of a battery cell and a voltage region of interest of the differential profile.

FIG. 8 is a diagram showing an example of a characteristic point selected in a differential profile of a battery cell corresponding to a normal condition.

FIG. 9 is a diagram showing an example of a characteristic point selected in a differential profile of a battery cell corresponding to an abnormal condition.

FIG. 10 is a diagram exemplarily illustrating a time-series change of a peak comparison value.

FIG. 11 is a diagram illustrating a voltage difference between two characteristic points.

## BEST MODE

Hereinafter, the exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are provided to describe the present disclosure for illustrative purposes and do not fully represent the technical aspect of the present disclosure, so it should be understood that a variety of other equivalents and modifications could have been made thereto at the time the application was filed.

The terms "first", "second" and the like, are used to distinguish one element from another among various elements, and not intended to limit the elements by the terms.

Unless the context clearly indicates otherwise, the terms "comprise" and "include" when used in this specification, specify the presence of stated elements, but do not preclude the presence or addition of one or more other elements. Additionally, the term "unit" as used herein refers to a processing unit of at least one function or operation, and may be implemented by hardware or software or a combination thereof.

In addition, throughout the specification, it will be further understood that when an element is referred to as being "connected to" another element, it may be directly connected to the other element or intervening elements may be present.

FIG. 1 is a block diagram showing a detailed configuration of a battery diagnosis apparatus 100 according to an embodiment of the present disclosure, and FIG. 4 is a flowchart illustrating a process of diagnosing the condition of a battery cell according to an embodiment of the present disclosure.

Referring to FIGS. 1 and 4, the battery diagnosis apparatus 100 may include a measurement unit 110, a profile processing unit 120, a data processing unit 130, a peak detection unit 140, a calculation unit 150, a diagnosis unit 160 and a management control unit 160.

The battery diagnosis apparatus 100 may be realized through a variety of combinational applications of electronic devices or components such as storage means, calculation processing means or input/output means (ASIC, a chipset, a logic circuit, a register, a communication modem, MCU, etc.). Accordingly, it should be understood that each component of the battery diagnosis apparatus 100 may be distinguishable physically, functionally or logically. The same is the case with each component of the calculation unit 150 and the diagnosis unit 160 shown in FIGS. 2 and 3.

That is, each component shown in the drawings corresponds to a logical component for effectively describing the technical aspect of the present disclosure, so it should be interpreted that each component accomplishing the function performed by the logical component of the present disclosure falls within the scope of the present disclosure even though they are combined or separated, and it should be also interpreted that the components performing identical or similar functions fall within the range of the present disclosure irrespective of whether the names are identical.

Additionally, the entire battery diagnosis method of the present disclosure may be realized as a set of processes or algorithms related to data processing, manipulation, control, calculation or input/output. The battery diagnosis method may be realized as a combination of logical components shown in FIG. 1 as well as in the form of software that is installed and runs on a system, a device, a computer (or its similar device), a BMS, a module or its subordinate components.

The battery diagnosis apparatus 100 is provided to diagnose a normal condition or an abnormal condition of a battery cell 50. According to embodiments, the battery diagnosis apparatus 100 may be configured to generate and output diagnosis data of the battery cell 50 by systematic connection with other component or module/device. Hereinafter, the battery cell 50 whose condition will be diagnosed may be referred to as 'target cell'.

The target cell 50 may include two or more types of active materials. Each active material may be included in a positive electrode or a negative electrode of the target cell 50.

The positive electrode active material may include, for example, $Li_2MnO_3$, $LiNi_aCo_bMn_cO_2$ (a, b, c≥0; a + b + c = 1) or $LiFe_xMn_{1-x}PO_4$ (x≥0). The so-called Mn-rich may be a positive electrode active material having the manganese content (c) of a predetermined level (for example, 0.5) or more in the three-component system (NMC) positive electrode material $LiNi_aCo_bMn_cO_2$. The $LiFe_xMn_{1-x}PO_4$ may be referred to as a LMFP positive electrode material. The negative electrode active material may include, for example, graphite or silicon-based active materials (for example, Pure Si, SiO, SiC, etc.).

A target cell 50 diagnosed and managed by the battery diagnosis apparatus 100 may be included in an upper level assembly such as a cell assembly, a battery module or a battery pack. In this case, the plurality of target cells 50 may be connected in series, in parallel or a combination thereof.

The measurement unit 110 may include at least one of a voltage sensor and a current sensor. The voltage sensor may measure the voltage of the target cell 50. The current sensor may measure the charge/discharge current flowing through the target cell 50. The measurement unit 110 may generate charge/discharge information (also referred to as 'measurement information') indicating the voltage and/or current of the target cell 50 in the charge /discharge process of the target cell 50.

In step S400, the profile processing unit 120 may collect the charge/discharge information of the target cell 50 from the measurement unit 110.

In step S410, the profile processing unit 120 may generate a battery profile of the target cell 50. Here, the battery profile (charge/discharge profile) may be a profile indicating a correspondence relationship between voltage and capacity (or SOC) of the target cell 50.

The profile processing unit 120 may generate the battery profile by performing a process of mapping voltage time series with capacity time series (or SOC time series) of the target cell 50 based on the time index. The battery profile may be received and stored by the profile processing unit 120 from an external device or module for future use.

The battery profile may be a set of data points or a polynomial indicating the relationship between voltage and capacity of the target cell 50 or the relationship between voltage and SOC. Each data point of the battery profile may be a pair of voltage value and capacity value (or SOC) indexed at the same time (the same measurement timing).

The voltage time series may indicate a time-dependent change history of the voltage of the target cell 50. The current time series may indicate a time-dependent change history of the current of the target cell 50. The capacity time series (or SOC time series) may be determined by applying ampere counting to the current time series.

The SOC is a parameter indicating a ratio of current capacity to maximum capacity and is represented as 0 to 1 or 0% to 100%, and various techniques and technologies such as current accumulation, equivalent circuit model or Kalman filter may be applied. According to embodiments, information associated with SOC may be generated, further reflecting environment information such as temperature information.

In step S420, the data processing unit 130 may generate a differential profile from the battery profile. Alternatively, the differential profile may be received and stored by the profile processing unit 120 from the external device or module for future use.

The differential profile may be a set of data points or a polynomial indicating a relationship between voltage and differential capacity of the target cell 50. Each data point of the differential profile may be a pair of voltage value and differential capacity value indexed at the same time (the same measurement timing).

The differential capacity is obtained by differentiating capacity with respect to voltage, and may be expressed as "dQ/dV", and its unit may be [Ah/V]. When the X axis of a two-dimensional coordinate corresponds to voltage and the Y axis corresponds to differential capacity, the differential profile (differential capacity profile) may be represented in the form of as a two-dimensional graph as shown in FIG. 7.

When function processing such as symmetric transformation or variable conversion is applied, the technical aspect of the present disclosure may be applied irrespective of whether the charge/discharge information on which the battery profile is based, is acquired during charging or discharging. At least one of charging and discharging of the target cell 50 may be performed at a constant current (CC).

As the target cell 50 degrades, the charge/-discharge characteristics of at least one active material of the target cell 50 may gradually change. In particular, there is a voltage range in which the charge/discharge characteristics of a specific active material change more greatly than other active material or the deviation of charge/discharge characteristics between active materials is too large, and accordingly, the condition of the specific active material may be estimated by analyzing the corresponding voltage range.

Accordingly, to clearly reflect the charge/-discharge characteristic deviation for each active material in the data processing, a part of the differential profile corresponding to a voltage region of interest (HV, see FIG. 7) may be set as a target on which the diagnosis process according to the present disclosure is done. In FIG. 7, the voltage region of interest HV is shown as 3.90 to 4.10 [V]. Alternatively, the differential profile may indicate the relationship between voltage and differential capacity over the voltage region of interest HV instead of the usable voltage area of the target cell 50.

The voltage region of interest HV may be predetermined in such a manner that a single peak point exists in the target cell BC at Beginning Of Life (BOL), but an additional peak point appears as the target cell BC degrades. The increasing number of peak points results from peak splitting as described below.

The reference voltage value may be referred to as a boundary voltage (i.e., the lower limit of the voltage region of interest) that separates the voltage region of interest from the remaining voltage region in the entire voltage range of the differential profile. The reference voltage value may be variably set according to the specification or type of the target cell 50. For example, when the battery cell is designed with the upper limit of the usable voltage range of 4.20 [V], the reference voltage value may be set to 3.90 [V] that is lower than the upper limit of the usable voltage range.

FIG. 7 shows an example of a reference differential profile, and FIGS. 8 and 9 show an example of the differential profile of each battery cell 50.

Referring to FIG. 7, the reference differential profile RP is schematically shown at the left top, and the up-scaled diagram at the lower side shows a part of the reference differential profile RP corresponding to the voltage region of interest HV on the basis of the X axis (voltage axis).

The reference differential profile RP may be pre-acquired to indicate the correspondence relationship between voltage and differential capacity of a reference cell. For example, the reference cell may be a battery cell manufactured with the same level of electrochemical characteristics and performance as the target cell 50 at BOL.

In step S430, the peak detection unit 140 may detect a peak point present in the differential profile.

The peak point may refer to a boundary point where the trend of the slope of the battery profile changes in the opposite direction, that is, a point where the sign of the slope increase rate changes (from positive to negative or from negative to positive). It refers to a point where a shape change of line or curve in the battery profile, i.e., a convex (upward convex)-concave (downward convex) change occurs. The peak point may be, for example, a maximum point, a minimum point or an inflection point.

Because each peak point indicates voltage-differential capacity information reflecting the charge/discharge characteristics of at least one active material of the target cell 50, it may be used as an important parameter indicating the current condition of the target cell 50.

For convenience of description, it is shown that each differential profile shown in FIGS. 7 to 9 is generated based on the charge/discharge information acquired during discharging. In this case, each minimum point located at the voltage region of interest HV may be detected as the peak point from the differential profile. The minimum point on the differential profile may be a point where the sign of the slope in the differential profile changes from negative to positive. For example, $CP_1$ and $CP_2$ of FIGS. 8 and 9 are two minimum points located in the differential profile of the target cell 50.

In step S440, the diagnosis unit 160 may determine if a plurality of peak points having voltage values within the voltage region of interest HV are detected from the differential profile of the target cell 50. That is, in step S440, determination is made as to the presence or absence of peak splitting caused by a change in charge/discharge characteristics of at least one active material of the target cell 50.

When the value of the step S440 is "No", the diagnosis unit 160 may diagnose the target cell 50 as a normal cell. As shown in FIG. 7, only one peak point $CP_R$ mapped to a specific voltage value $V_R$ in the voltage region of interest HV may exist in the reference differential profile RP of the reference cell. Accordingly, when only one peak point is identified in the differential profile of the target cell 50, the diagnosis unit 160 may diagnose the target cell 50 as normal. Along with or in place of this, an additional diagnosis process may be performed on the target cell 50 in step S445.

In contrast, as shown in FIGS. 8 and 9, two or more peak points may exist in the differential profile of the target cell 50. In this case, the value of the step S440 is "Yes", and the subsequent procedure, step S450 may be performed.

In step S450, the calculation unit 150 may determine any two $CP_1$, $CP_2$ of the plurality of peak points detected in step S430 as a first peak point and a second peak point. In the specification, the first peak point and the second peak point may be referred collectively to as 'characteristic point'. An embodiment of selecting the characteristic point will be described in detail below.

Subsequently, in step S460, the calculation unit 150 determines a peak comparison value based on the two characteristic points $CP_1$, $CP_2$.

For reference, the calculation unit 150 may update history data indicating a change history of the peak comparison value each time the peak comparison value is determined. The calculation unit 150 may identify the previous peak comparison value based on the history data. The previous peak comparison value may refer to a peak comparison value determined earlier than the currently determined peak comparison value.

In step S470, the diagnosis unit 160 may diagnose the condition of the target cell 50 based on the peak comparison value determined by the step S460.

The diagnosis unit 160 may compare the peak comparison value with a reference comparison value and determine whether the target cell 50 is normal or abnormal based on the comparison result. When the peak comparison value is larger than the reference comparison value, the diagnosis unit 160 may diagnose the target cell 50 as an abnormal cell. In contrast, when the peak comparison value of the target cell 50 is smaller than the reference comparison value, the diagnosis unit 160 may diagnose the target cell 50 as a normal cell. The diagnosis of the target cell 50 by the diagnosis unit 160 will be described in detail below.

According to embodiments, for systematic connection with the subsequent control process or other configuration and time series characteristics analysis, the diagnosis unit 140 is preferably configured to generate and store diagnosis information or history information in which time information at which the target cell 50 is determined as normal or abnormal is combined with identification information of the target cell 50.

In step S480, the diagnosis unit 160 may determine whether a preset termination condition is met. When it is determined that the termination condition is not met (step S480: No), the above-described process of the present disclosure may be applied cyclically. The termination condition may be, for example, forced termination, system-down, an emergency event, etc.

FIG. 2 is a block diagram exemplarily showing the detailed configuration of the calculation unit 150 shown in FIG. 1, FIG. 5 is a flowchart exemplarily illustrating the process for generating the peak comparison value of the battery cell 50, and FIG. 11 is a diagram illustrating a voltage difference between the two characteristic points. Hereinafter, the embodiment of the present disclosure of generating the peak comparison value will be described in detail with reference to the drawings.

Referring to FIG. 2, the calculation unit 150 may include at least one of a reference storage unit 151, a counting unit 153, a selection unit 155 and a calculation processing unit 157. Each component of the calculation unit 150 shown in FIG. 2 may correspond to a physical or logical component as described above.

The reference cell is a battery cell having little or no deviation of charge/discharge characteristics between active materials. Accordingly, as shown in FIG. 7, only the single peak point $CP_R$ may be located at the part corresponding to the specific voltage range HV in the differential profile of the reference cell, i.e., the reference differential profile RP. To distinguish it from the peak point of the target cell 50, the peak point of the reference differential profile RP will be referred to as 'reference peak point'.

The reference storage unit 151 may pre-store information associated with the reference peak point. For example, when the reference differential profile RP is generated from the reference battery profile indicating the voltage-capacity relationship as the characteristic during discharge of the reference cell, the minimum point having a voltage value within the voltage region of interest HV in the reference differential profile RP may be the reference peak point.

In step S510, the counting unit 153 counts the number of peak points based on the peak detection data received from the peak detection unit 140.

In step S520, the counting unit 153 determines whether the number of peak points counted in the step S510 is equal to or larger than two. When the value of the step S520 is "No", the method may proceed with step S525. When the value of the step S520 is "Yes", the method may proceed with step S530.

In step S525, the counting unit 153 may generate result data indicating the single peak point. The result data may be output to the diagnosis unit 160. The diagnosis unit 160 may diagnose the target cell 50 as normal based on the result data received from the counting unit 153.

In step S530, the selection unit 155 determines any two of the plurality of peak points as the first peak point and the second peak point. Specifically, any one of the plurality of peak points having a smallest voltage difference from the reference peak point may be selected as the first peak point. For example, referring to FIG. 8, among the voltage values V1, V2 of the two peak points $CP_1$ and $CP_2$, the voltage value V1 is closer to the voltage value $V_R$ of the reference peak point, and thus, among $CP_1$ and $CP_2$, $CP_1$ is the first peak point selected as the characteristic point.

When the target cell 50 degrades, peak splitting occurs as described above, and thus, the number of peak points detected in the voltage region of interest HV may be equal to or larger than two. In particular, peak splitting may occur more noticeably as the cycle (use) is repeated due to the relative deviation of the degree of degradation between the two or more types of active materials in the positive electrode and/or the negative electrode of the battery cell 50 and between the active material of the positive electrode and the active material of the negative electrode.

The selection unit 155 may determine the other one of the plurality of peak points as the second peak point based on the first peak point $CP_1$. Specifically, among the peak points present in the low voltage range based on the voltage value of the first peak point $CP_1$, a peak point having a smallest voltage difference from the first peak point may be determined as the second peak point. For example, referring back to FIG. 8, the peak point $CP_2$ may be determined as the second peak point.

Although not shown, when the voltage value of a peak point having the smallest voltage difference from the first peak point $CP_1$ is lower than the reference voltage value (for example, 3.90 V), there is a very high likelihood that the peak point is caused by the charge/-discharge characteristics of the active material that is different from the first peak point active material. Accordingly, it is preferable to determine, as the second peak point, one of the plurality of peak points that meets the following conditions: (i) having a smaller voltage value than the voltage value of the first peak point, (ii) having a smallest voltage difference from the first peak point, and (iii) having a voltage value equal to or larger than the reference voltage value.

As described above, when the two characteristic points $CP_1$, $CP_2$ are selected as the criteria for determining if the deviation of charge/discharge characteristics between active materials is too large, in the step S540, the calculation processing unit 157 may compare the first and second peak points $CP_1$, $CP_2$ to generate the

peak comparison value of the target cell 50. The following Equation may be used to determine the peak comparison value.

<Equation>

$$DR = \frac{f(V_2)}{f(V_1)}$$

Assume that the function f(V)= dQ/dV is a polynomial corresponding to the differential profile of the target cell 50 shown in FIG. 8. In the above Equation, DR is the peak comparison value of the target cell 50, $f(V_1)$ is the differential capacity value of the first peak point $CP_1$, and $f(V_2)$ is the differential capacity value of the second peak point $CP_2$. As an example, the peak comparison value DP based on the two characteristic points $CP_1$, $CP_2$ shown in FIG. 8 is $f(V_2)/f(V_1) = dq_{12}/dq_{11}$. As another example, the peak comparison value DP based on the two characteristic points $CP_1$, $CP_2$ shown in FIG. 9 is $f(V_2)/f(V_1) = dq_{22}/dq_{21}$. For reference, Profile 1 shown in FIG. 8 is the differential profile of the target cell 50 when the target cell 50 is in the first condition, and Profile 2 shown in FIG. 9 is the differential profile of the target cell 50 when the target cell 50 is in the second condition that is more degraded than the first condition.

In step S550, the calculation processing unit 157 may output comparison data (for example, the peak comparison value) indicating the comparison result by the step S540 to the diagnosis unit 160.

In step S560, the diagnosis unit 160 may determine if the preset termination condition is met. When the value of the step S560 is "No" the above-described steps performed by the calculation unit 150 may be also performed cyclically. The step S560 may be substantially the same as the step S480.

The diagnosis process of the present disclosure may be configured to track characteristics changes in time series with the increasing duration of use or cycling count of the target cell 50.

Accordingly, the differential profile of the target cell 50 may be updated regularly or irregularly, and the peak detection unit 140 may perform the operation of selecting the peak points from the updated differential profile again. In addition, the calculation unit 150 may be configured to perform the operation of determining the peak comparison value of the target cell 50 again based on the peak points selected from the updated differential profile. The diagnosis unit 160 may track the condition of the target cell 50 over the entire life of the target cell 50 through the comparison of the newly determined peak comparison value with the reference comparison value (S470).

The calculation processing unit 157 may determine the voltage difference between the two characteristic points. Referring to FIG. 11, D1 denotes the voltage difference between the two characteristic points detected from the Profile 1, and D2 denotes the voltage difference between the two characteristic points detected from the Profile 2.

The voltage difference between the two characteristic points may be a quantitative value indicating behavioral characteristics that increase as the target cell 50 degrades. Accordingly, additional data indicating the condition of the target cell 50 may be acquired by comparing the voltage difference between the two characteristic points with the reference voltage difference, or tracking a time series change trend of the voltage difference between the two characteristic points.

When the calculation processing unit 157 further generates the voltage difference between the first and second peak points, the diagnosis unit 160 may diagnose the current condition of the target cell 50 more precisely further based on information about the voltage difference. As an example, the diagnosis unit 160 may determine the target cell 50 as abnormal when both a first condition and a second condition are met, the first condition in which the peak comparison value is larger than the reference comparison value, and the second condition in which the voltage difference between the first and second peak points is larger than the reference voltage difference.

FIG. 3 is a block diagram exemplarily showing the detailed configuration of the diagnosis unit 160 shown in FIG. 1, FIG. 6 is a flowchart illustrating the process of diagnosing the condition of the battery cell 50 according to an embodiment of the present disclosure, and FIG. 10 is a diagram exemplarily illustrating the time-series change of the peak comparison value.

As shown in FIGS. 3, 6 and 10, the diagnosis unit 160 may include a reference information storage unit 161, a diagnosis processing unit 165 and an information generation unit 167.

The reference information storage unit 161 may pre-store information associated with the reference comparison value. The reference comparison value may be compared with the peak comparison value, and may be preset information used to determine if the target cell 50 is normal.

When the plurality of peak points exist in the voltage region of interest HV due to peak splitting, but the two differential capacity values of the first peak point and the second peak point having high relevance to the reference peak point are at the equal level, the target cell 50 may be treated as a cell in normal operating condition. Accordingly, when the peak comparison value is determined according to the above Equation, the reference comparison value may be set to 1.

The reference comparison value may be variably set by additionally reflecting information associated with the safety level of a device on which the target cell 50 is mounted, the service life, capacity characteristics or State Of Health (SOH) of the target cell 50, the types of active materials and/or the preset mix ratio of active materials.

In step S620, the diagnosis processing unit 165 may determine if the peak comparison value of the target cell 50 received from the calculation unit 150 is larger than the reference comparison value.

The graph shown in FIG. 10 corresponds to the history data of the peak comparison value with increasing cycle number, wherein the X axis indicates the cycle number and the Y axis indicates the peak comparison value. The cycle number may refer to the number of times the target cell 50 is charged and discharged by a predetermined charging protocol (for example, constant current - constant voltage charging over the usable voltage range) and a predetermined discharging protocol (for example, constant current discharging over the usable voltage range).

Referring to FIG. 10, when the peak comparison value is larger than the reference comparison value (for example, 1.00) as in the range B1, the value of the step S620 is "Yes". When the value of the step S620 is "Yes", the method may proceed with step S630. When degradation imbalance between the different types of active materials included in the target cell 50 and/or degradation of the target cell 50 itself is outside of the normal range, the output value of the step S620 may be "Yes".

On the other hand, when the peak comparison value is equal to or smaller than the reference comparison value as in the range A2, the value of the step S620 is "No". When the value of the step S620 is "No", the method may proceed with step S640.

In step S630, the diagnosis processing unit 165 may determine the target cell 50 as abnormal. When the target cell 50 is diagnosed as abnormal by the diagnosis unit 160, in step S650, the management control unit 170 may perform control to limit the charge/discharge of the target cell 50 (for example, the range of SOC and/or capacity, maximum usable time, voltage at which the target cell 50 can be charged, voltage at which the target cell 50 can be discharged, etc.).

In step S640, the diagnosis processing unit 165 may diagnose the target cell 50 as normal. Specifically, when only one peak point is detected in the voltage region of interest HV as shown in FIG. 7 due to no peak splitting, the calculation processing unit 157 may not perform the operation for determining the peak comparison value. Instead, the diagnosis processing unit 165 may set the peak comparison value to a predetermined value (for example, 0) that is smaller than the reference comparison value.

As an example, FIG. 10 does not plot any point indicating the peak comparison value in the range A1, showing that only one peak point is detected in the voltage region of interest HV for the duration corresponding to the range A1.

As another example, FIG. 10 plots the plurality of points in the range A2, showing that the plurality of peak points are detected in the range A2, as opposed to the range A1. However, because the peak comparison values of all the points in the range A2 are smaller than the reference comparison value, the diagnosis processing unit 165 may diagnose the target cell 50 as normal in the range A2.

The information generation unit 167 may be configured to generate diagnosis information (for example, identification information, time information at which the target cell 50 is determined as abnormal, etc.) of the target cell 50 diagnosed as abnormal, and output the generated diagnosis information to a user terminal and/or a vehicle's info system. The step S660 may substantially the same as the step S480.

Meanwhile, the range B2 shown in FIG. 10 corresponds to a higher cycle number than the range B1. Accordingly, those skilled in the art will easily understand that degradation imbalance between active materials of the target cell 50 will be more severe in the range B2 than the range B1.

The range B2 is similar to the range A1 in that any point is not plotted in there. However, the reason why there are no point plotted in the range B2 may be that peak splitting has already occurred, but becomes so severe that the second peak point is shifted to the lower voltage than the lower limit (i.e., the reference voltage value) of the voltage region of interest. When the second peak point is shifted to the left and the voltage value of the second peak point is smaller than the reference voltage value, only one peak point $CP_1$ may exist within the voltage region of interest HV, and then the operation of determining the peak comparison value by the diagnosis processing unit 165 is not performed, so there is no point plotted in the range B2. Accordingly, the reason why there is no point plotted in the range B2 is distinctly different from the reason why there is no point plotted in the range A1.

The diagnosis processing unit 165 may generate a message that the target cell 50 cannot be used when the shift event from the range B1 to the range B2 occurs. The shift event may be equivalent to an event in which the voltage value of the second peak point as the characteristic point decreases below the reference voltage value. The presence or absence of the shift event may be identified from the history data of the peak comparison value. The message may notify a user that it is necessary to interrupt the charge and discharge of the target cell 50 and/or replace with another battery cell.

The battery diagnosis apparatus 100 may be applied to a Battery Management System (BMS). That is, the BMS may include the above-described battery diagnosis apparatus 100. In this case, at least some of the components of the battery diagnosis apparatus 100 may be implemented by complementing or adding the functions of the components included in the conventional BMS.

Additionally, the battery diagnosis apparatus 100 may be equipped in a battery pack. That is, the battery pack may include the battery diagnosis apparatus 100 and at least one battery cell, a battery assembly, a battery module or a battery cell group.

Further, the battery diagnosis apparatus 100 may be equipped in a vehicle such as an electric vehicle or a hybrid electric vehicle. That is, the vehicle according to the present disclosure may include the battery diagnosis apparatus according to the present disclosure or the battery pack according to the present disclosure. Additionally, in addition to the battery diagnosis apparatus or the battery pack, the vehicle according to the present disclosure may further include any other component included in the vehicle. For example, in addition to the apparatus according to the present disclosure, the vehicle according to the present disclosure may further include a vehicle body, a motor, or a controller such as an electronic control unit (ECU).

The above-described embodiments of the present disclosure are not embodied only through the apparatus and method, and may be implemented through programs that perform the functions corresponding to the exemplary configurations of the present disclosure or recording media having the programs recorded thereon, and such implementation may be easily achieved by those skilled in the art from the foregoing description of the embodiments.

Although the present disclosure has been hereinabove described with regard to certain embodiments and drawings, the present disclosure is not limited thereto and a variety of modifications and changes may be made by those skilled in the art within the technical aspect of the present disclosure and the scope of the appended claims and their equivalents.

Additionally, as many substitutions, modifications and changes may be made to the present disclosure as described above by those skilled in the art without departing from the technical aspect of the present disclosure, the present disclosure is not limited by the above-described embodiments and the accompanying drawings, and some or all of the embodiments may be selectively combined to allow various modifications.

## Claims

**1.** A battery diagnosis apparatus comprising:

a data processing unit configured to acquire a differential profile indicating charge/discharge characteristics of a battery cell;
a calculation unit configured to determine a peak comparison value based on a first peak point and a second peak point, wherein the first peak point and the second peak point are any two of a plurality of peak points when the plurality of peak points exist in the differential profile; and
a diagnosis unit configured to diagnose a condition of the battery cell based on the peak comparison value.

**2.** The battery diagnosis apparatus according to claim 1,
wherein the first peak point and the second peak point indicate the charge/discharge characteristics of two active materials included in the battery cell.

**3.** The battery diagnosis apparatus according to claim 1, further comprising:
a management control unit configured to perform control to limit the charge and discharge of the battery cell when the battery cell is diagnosed as abnormal.

**4.** The battery diagnosis apparatus according to claim 1,
wherein the calculation unit is configured to:

determine any one of the plurality of peak points having a smallest voltage difference from a reference peak point as the first peak point, and
determine the other one of the plurality of peak points having a smaller voltage value than the first peak point and a smallest voltage difference from the first peak point as the second peak point.

**5.** The battery diagnosis apparatus according to claim 1,
wherein the calculation unit is configured to:
determine the peak comparison value based on a ratio between a differential capacity value of the first peak point and a differential capacity value of the second peak point.

**6.** The battery diagnosis apparatus according to claim 1,
wherein the diagnosis unit is configured to:

diagnose the battery cell as abnormal when the peak comparison value is larger than a reference comparison value, and
diagnose the battery cell as normal when the peak comparison value is equal to or smaller than the reference comparison value.

**7.** The battery diagnosis apparatus according to claim 1,
wherein the diagnosis unit is configured to:
generate diagnosis information indicating that the battery cell is abnormal when the battery cell is diagnosed as abnormal.

**8.** The battery diagnosis apparatus according to claim 1,
wherein the diagnosis unit is configured to:
diagnose the condition of the battery cell based on history data of the peak comparison value when a single peak point exists in the differential profile.

**9.** The battery diagnosis apparatus according to claim 8,
wherein the diagnosis unit is configured to:
diagnose the battery cell as abnormal when at least one previous peak comparison value is identified from the history data.

**10.** The battery diagnosis apparatus according to claim 8,
wherein the diagnosis unit is configured to:
diagnose the battery cell as normal when a previous peak comparison value is not identified from the history data.

**11.** A battery pack comprising the battery diagnosis apparatus according to any one of claims 1 to 10.

**12.** A vehicle comprising the battery diagnosis apparatus according to any one of claims 1 to 10.

**13.** A battery diagnosis method comprising the steps of:

acquiring a differential profile indicating charge/-discharge characteristics of a battery cell;
determining a peak comparison value based on a first peak point and a second peak point, wherein the first peak point and the second peak point are any two of a plurality of peak points when the plurality of peak points exist in the differential profile; and
diagnosing a condition of the battery cell based on the peak comparison value.

**14.** The battery diagnosis method according to claim 13, wherein the step of determining the peak comparison value comprises the steps of:

determining any one of the plurality of peak points having a smallest voltage difference from a reference peak point as the first peak point; and
determining the other one of the plurality of peak points having a smaller voltage value than the first peak point and a smallest voltage difference from the first peak point as the second peak point.

**15.** The battery diagnosis method according to claim 13, wherein the step of determining the peak comparison value comprises:
determining the peak comparison value based on a ratio between a differential capacity value of the first peak point and a differential capacity value of the second peak point.

FIG. 1

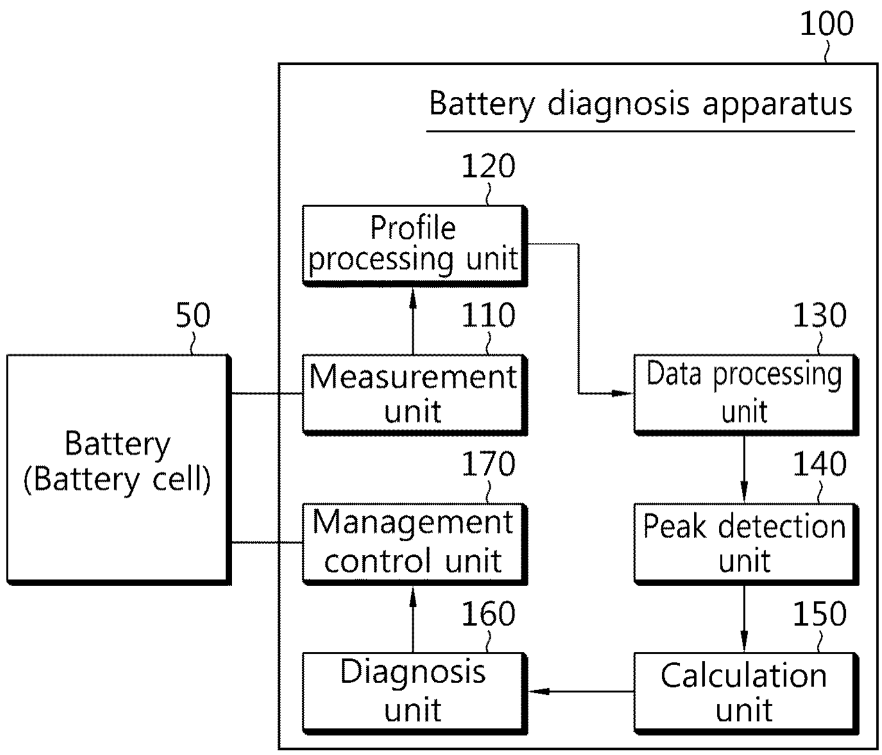
100
Battery diagnosis apparatus
120
Profile processing unit
50
110
130
Battery (Battery cell)
Measurement unit
Data processing unit
170
140
Management control unit
Peak detection unit
160
150
Diagnosis unit
Calculation unit

FIG. 2

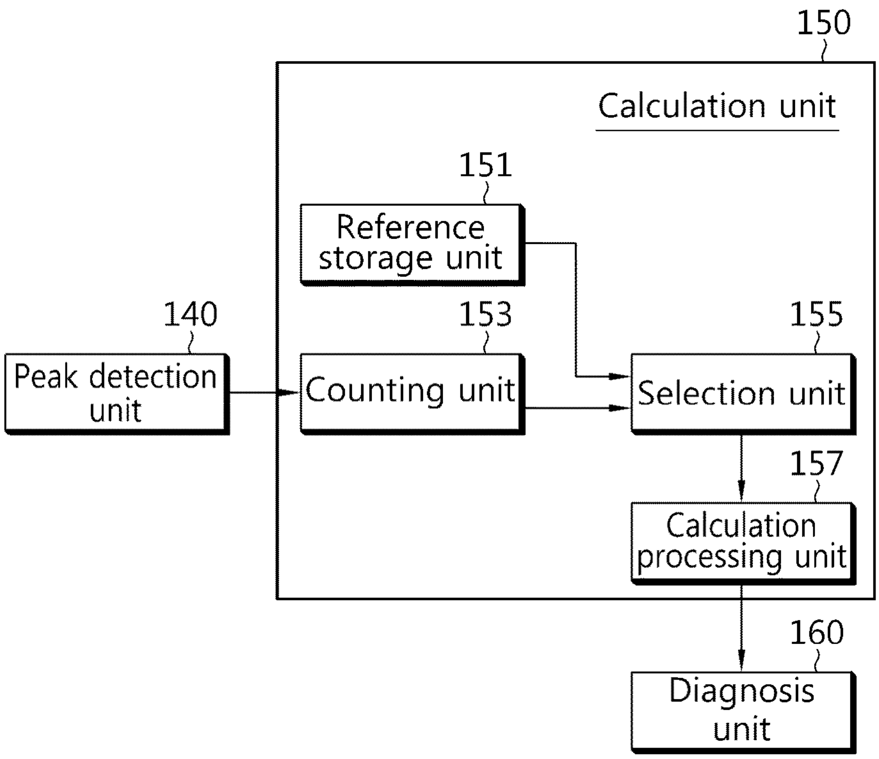
150
Calculation unit
151
Reference storage unit
140
153
155
Peak detection unit
Counting unit
Selection unit
157
Calculation processing unit
160
Diagnosis unit

FIG. 3

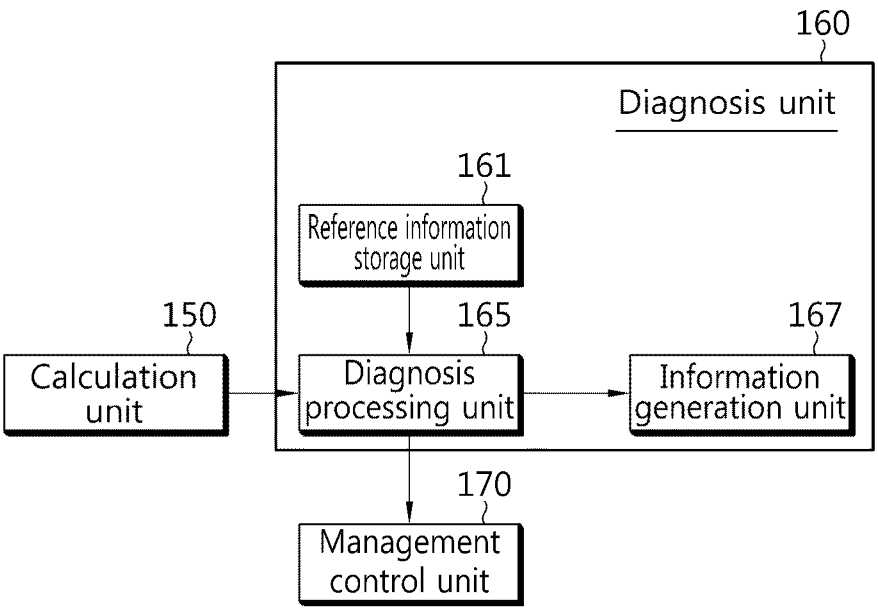
160
Diagnosis unit
161
Reference information storage unit
150
Calculation unit
165
Diagnosis processing unit
167
Information generation unit
170
Management control unit

FIG. 4

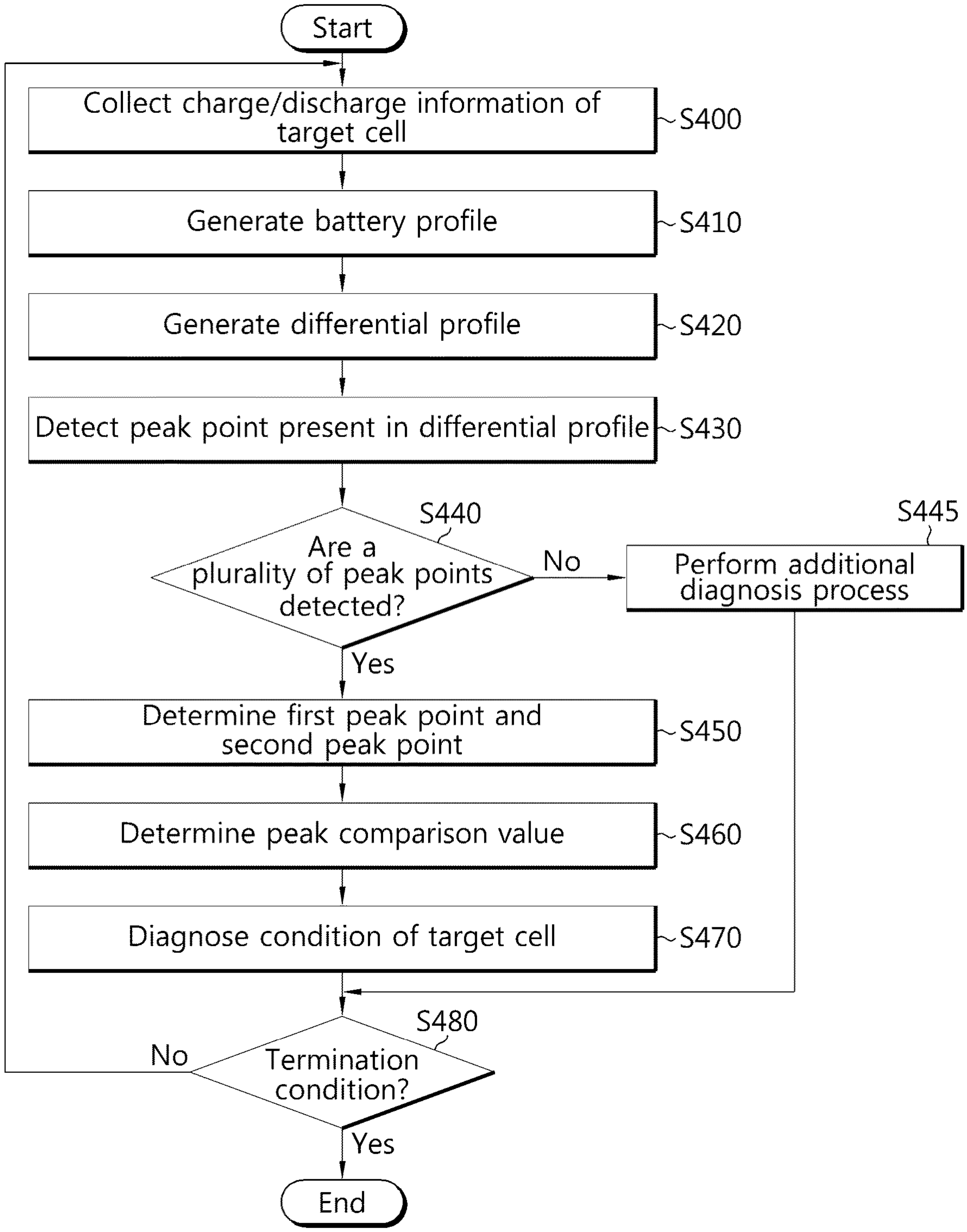
Start
Collect charge/discharge information of target cell
S400
Generate battery profile
S410
Generate differential profile
S420
Detect peak point present in differential profile
S430
S440
Are a plurality of peak points detected?
No
S445
Perform additional diagnosis process
Yes
Determine first peak point and second peak point
S450
Determine peak comparison value
S460
Diagnose condition of target cell
S470
S480
No
Termination condition?
Yes
End

FIG. 5

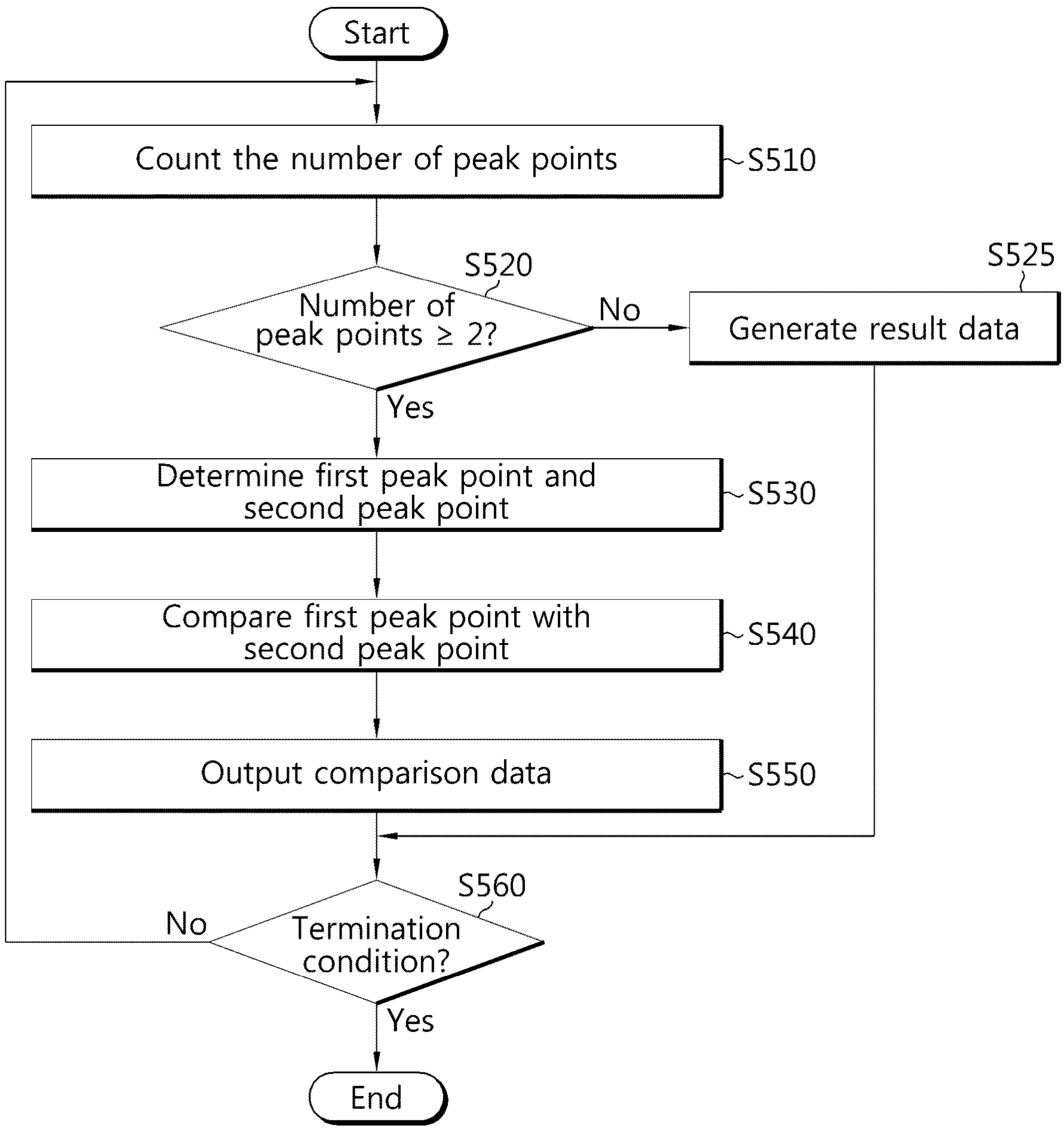
Start
Count the number of peak points
S510
S520
Number of peak points ≥ 2?
No
S525
Generate result data
Yes
Determine first peak point and second peak point
S530
Compare first peak point with second peak point
S540
Output comparison data
S550
S560
No
Termination condition?
Yes
End

FIG. 6

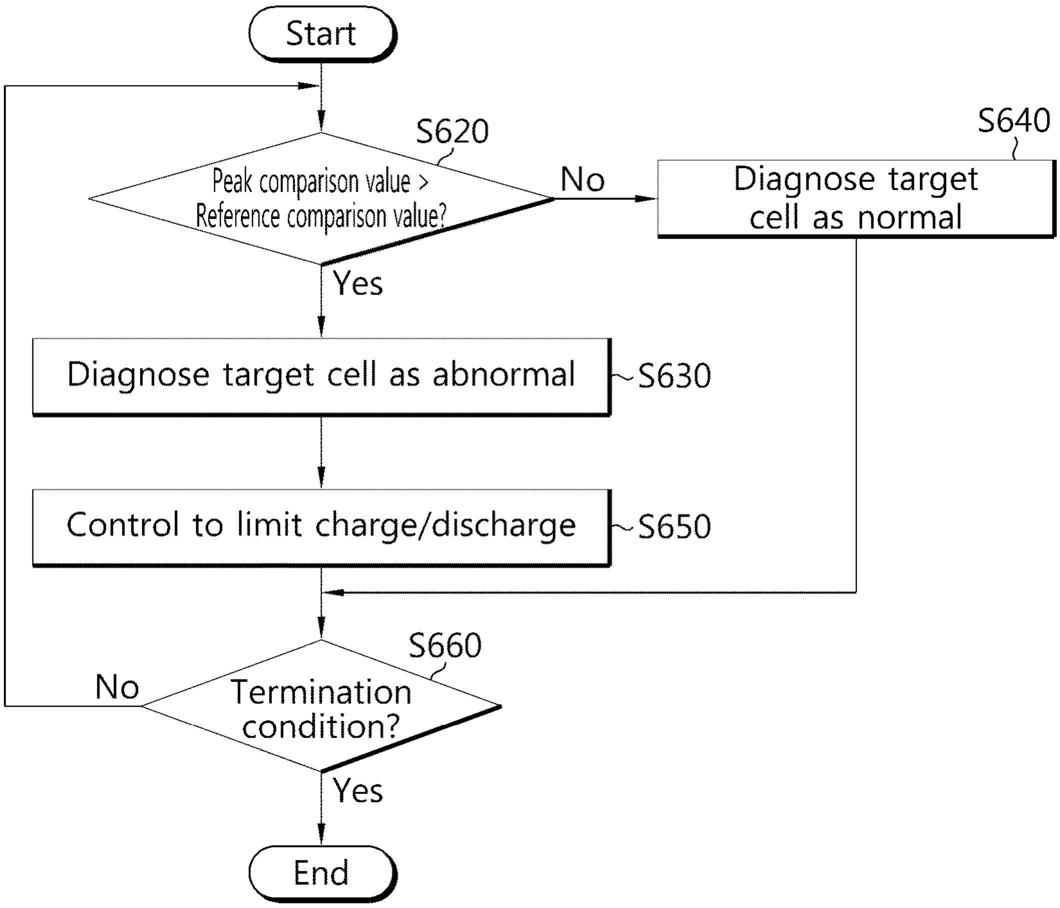
Start
S620
Peak comparison value > Reference comparison value?
No
S640
Diagnose target cell as normal
Yes
Diagnose target cell as abnormal
S630
Control to limit charge/discharge
S650
S660
No
Termination condition?
Yes
End

FIG. 7

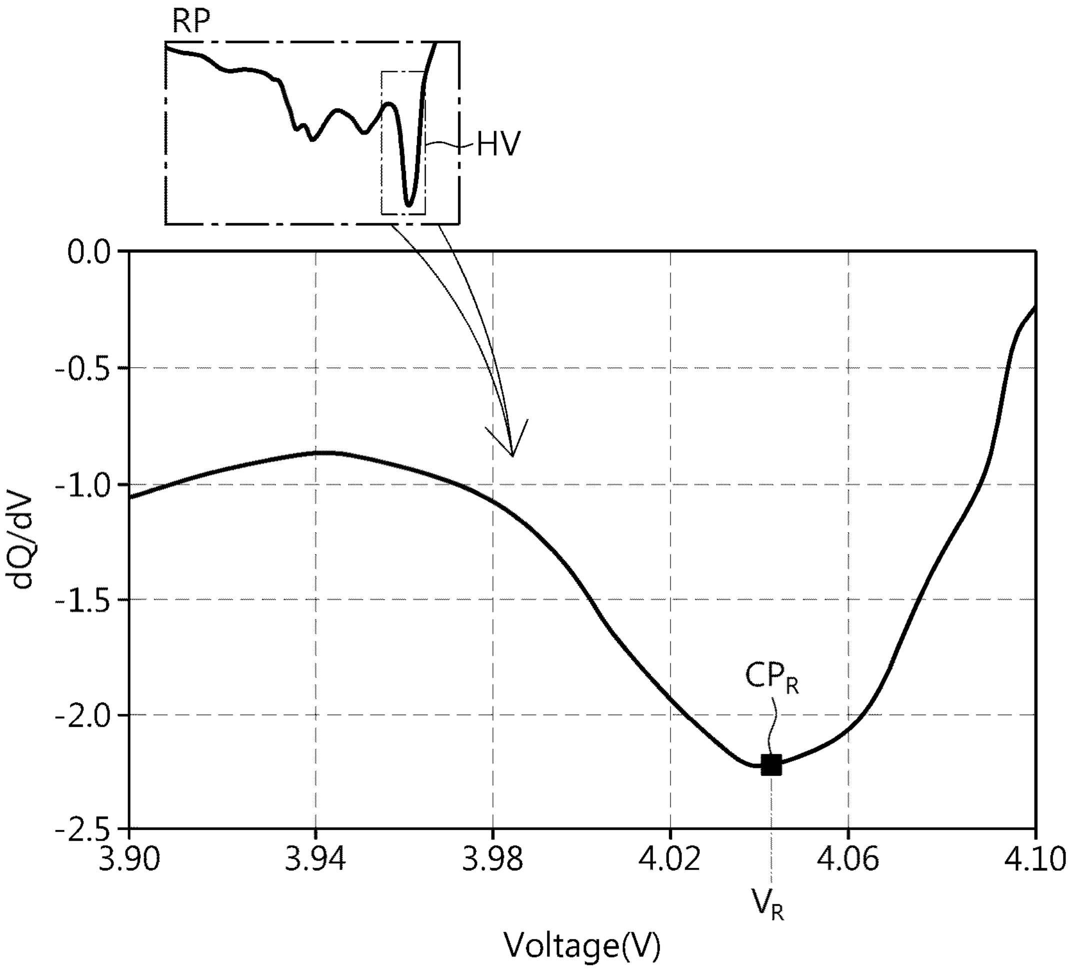
RP
HV
0.0
-0.5
-1.0
-1.5
-2.0
-2.5
dQ/dV
$CP_R$
3.90
3.94
3.98
4.02
4.06
4.10
$V_R$
Voltage(V)

FIG. 8

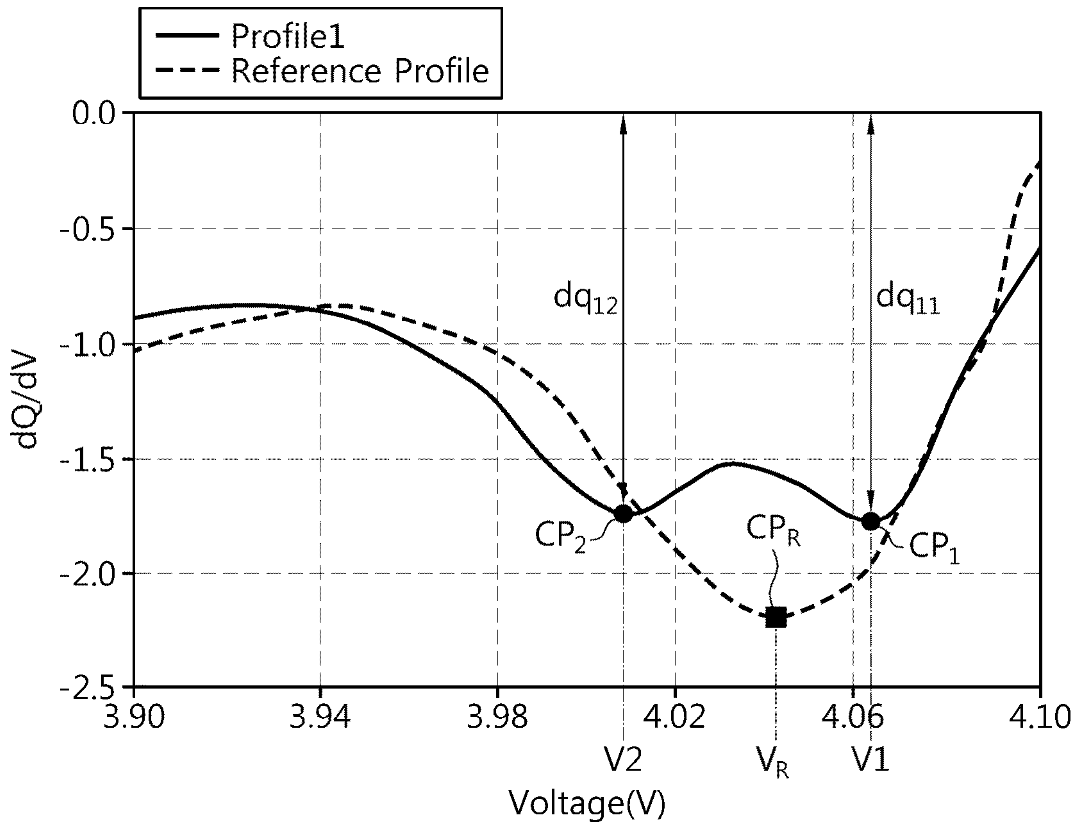
Profile1
Reference Profile
0.0
-0.5
-1.0
-1.5
-2.0
-2.5
dQ/dV
dq12
dq11
CP2
CPR
CP1
3.90
3.94
3.98
4.02
4.06
4.10
V2
VR
V1
Voltage(V)

FIG. 9

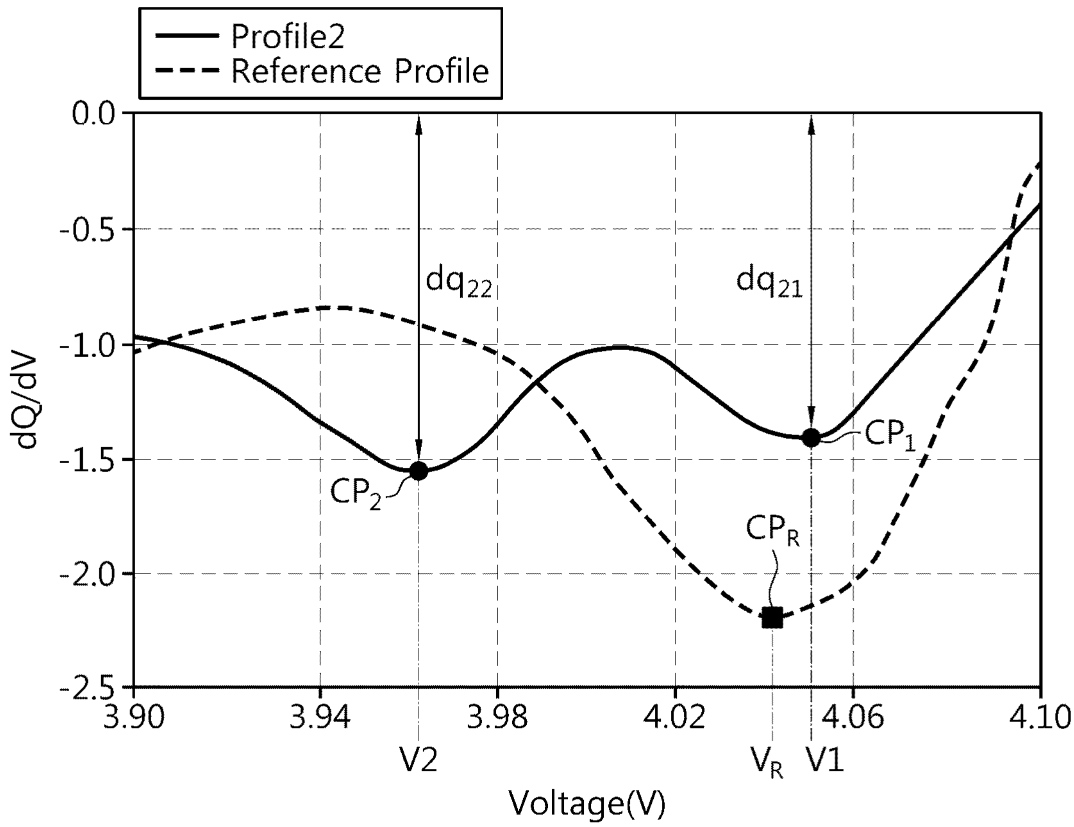
Profile2
Reference Profile
0.0
-0.5
-1.0
-1.5
-2.0
-2.5
dQ/dV
dq22
dq21
CP1
CP2
CPR
3.90
3.94
3.98
4.02
4.06
4.10
V2
VR
V1
Voltage(V)

FIG. 10

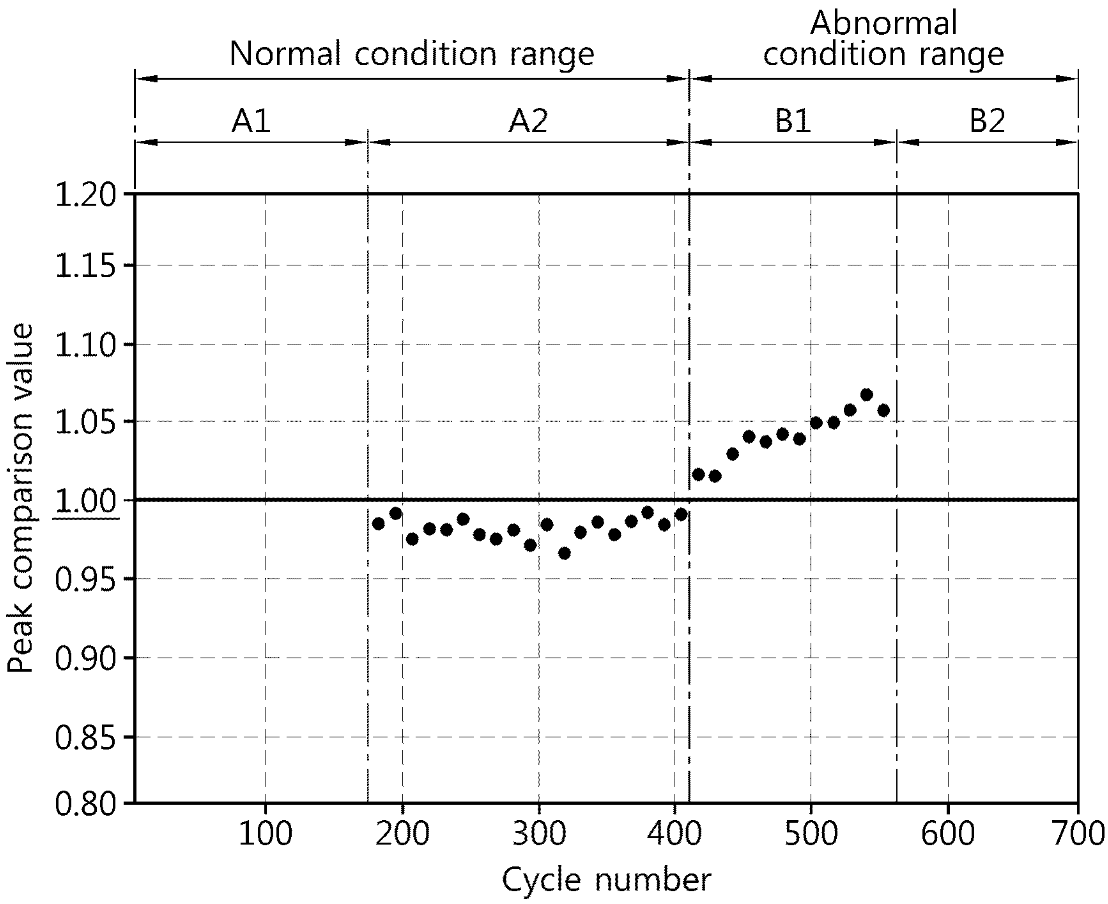
Normal condition range
Abnormal condition range
A1
A2
B1
B2
Peak comparison value
1.20
1.15
1.10
1.05
1.00
0.95
0.90
0.85
0.80
100
200
300
400
500
600
700
Cycle number

FIG. 11

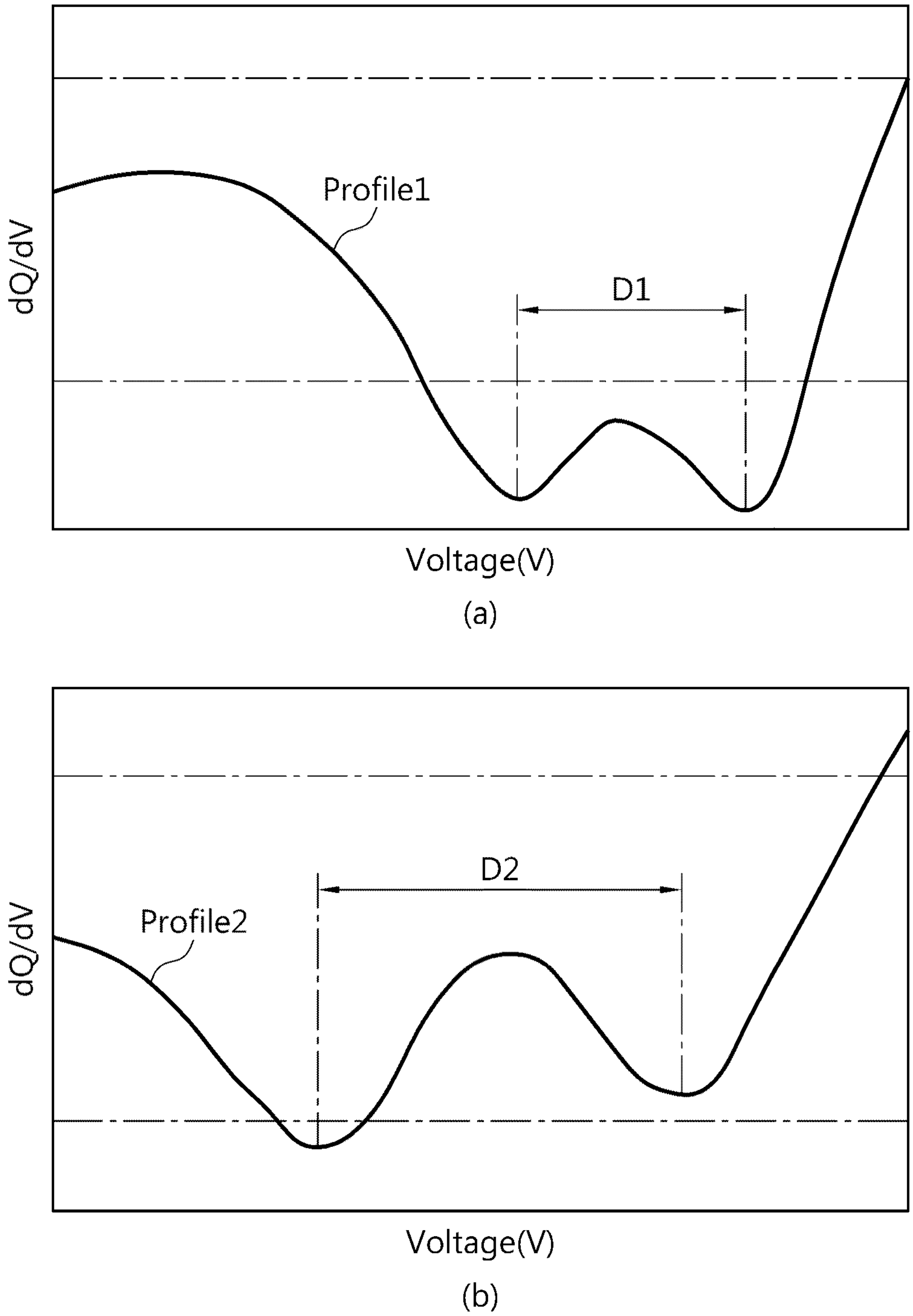

## INTERNATIONAL SEARCH REPORT

International application No.

**PCT/KR2024/017773**

**A. CLASSIFICATION OF SUBJECT MATTER**

**G01R 31/396**(2019.01)i; **G01R 31/3842**(2019.01)i; **G01R 31/392**(2019.01)i; **G01R 31/367**(2019.01)i; **G01R 19/165**(2006.01)i; **G01R 19/10**(2006.01)i; **B60L 58/10**(2019.01)i

According to International Patent Classification (IPC) or to both national classification and IPC

**B. FIELDS SEARCHED**

Minimum documentation searched (classification system followed by classification symbols)

G01R 31/396(2019.01); G01R 31/36(2006.01); G01R 31/367(2019.01); G01R 31/3842(2019.01); G01R 31/385(2019.01); G01R 31/392(2019.01); H01M 10/44(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 진단 장치(battery diagnostic device), 미분 프로파일(differential profile), 복수의 피크 포인트(multiple peak points), 충방전(charge/discharge), 퇴화(deterioration)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2021-0141096 A (LG ENERGY SOLUTION, LTD.) 23 November 2021 (2021-11-23)<br>See paragraphs [0012], [0029], [0057], [0069], [0070] and [0078]; claims 1 and 11; and figure 5. | 1-15 |
| Y | KR 10-2020-0018308 A (LG CHEM, LTD.) 19 February 2020 (2020-02-19)<br>See paragraphs [0001] and [0028]; and claim 6. | 1-15 |
| A | KR 10-2021-0040423 A (THE REGENTS OF THE UNIVERSITY OF MICHIGAN et al.) 13 April 2021 (2021-04-13)<br>See entire document. | 1-15 |
| A | JP 2017-059386 A (TOSHIBA CORP.) 23 March 2017 (2017-03-23)<br>See entire document. | 1-15 |
| A | KR 10-2016-0026766 A (YOKOGAWA ELECTRIC CORPORATION) 09 March 2016 (2016-03-09)<br>See entire document. | 1-15 |

☐ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **25 February 2025** | **25 February 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2024/017773**

| Patent document cited in search report | Publication date (day/month/year) | Patent family member(s) | Publication date (day/month/year) |
|---|---|---|---|
| KR 10-2021-0141096 A | 23 November 2021 | CN 115210594 A | 18 October 2022 |
| | | EP 4155747 A1 | 29 March 2023 |
| | | EP 4155747 A4 | 20 September 2023 |
| | | JP 2023-515057 A | 12 April 2023 |
| | | JP 7473106 B2 | 23 April 2024 |
| | | KR 10-2710437 B1 | 25 September 2024 |
| | | US 2023-0194620 A1 | 22 June 2023 |
| | | WO 2021-230537 A1 | 18 November 2021 |
| KR 10-2020-0018308 A | 19 February 2020 | CN 111418107 A | 14 July 2020 |
| | | CN 111418107 B | 25 August 2023 |
| | | EP 3703177 A1 | 02 September 2020 |
| | | EP 3703177 A4 | 24 February 2021 |
| | | EP 3703177 B1 | 04 January 2023 |
| | | KR 10-2326437 B1 | 15 November 2021 |
| | | US 11456493 B2 | 27 September 2022 |
| | | US 2021-0167432 A1 | 03 June 2021 |
| | | WO 2020-032545 A1 | 13 February 2020 |
| KR 10-2021-0040423 A | 13 April 2021 | CN 113272667 A | 17 August 2021 |
| | | EP 3833993 A1 | 16 June 2021 |
| | | EP 3833993 A4 | 20 April 2022 |
| | | US 2021-0359347 A1 | 18 November 2021 |
| | | WO 2020-033343 A1 | 13 February 2020 |
| JP 2017-059386 A | 23 March 2017 | JP 6437407 B2 | 12 December 2018 |
| KR 10-2016-0026766 A | 09 March 2016 | CN 105388422 A | 09 March 2016 |
| | | CN 105388422 B | 25 June 2019 |
| | | EP 2990818 A2 | 02 March 2016 |
| | | EP 2990818 A3 | 13 April 2016 |
| | | EP 2990818 B1 | 27 November 2019 |
| | | JP 2016-053564 A | 14 April 2016 |
| | | JP 6123844 B2 | 10 May 2017 |
| | | KR 10-1878538 B1 | 13 July 2018 |
| | | US 10126369 B2 | 13 November 2018 |
| | | US 2016-0061908 A1 | 03 March 2016 |

Form PCT/ISA/210 (patent family annex) (July 2022)

## REFERENCES CITED IN THE DESCRIPTION

*This list of references cited by the applicant is for the reader’s convenience only. It does not form part of the European patent document. Even though great care has been taken in compiling the references, errors or omissions cannot be excluded and the EPO disclaims all liability in this regard.*

### Patent documents cited in the description


- KR 1020230175821